# EUROPÄISCHE PATENTANMELDUNG

(11) **EP 0 680 100 A2**
(43) Veröffentlichungstag der Anmeldung: **02.11.1995**
(21) Anmeldenummer: 95106283.5
(22) Anmeldetag: 26.04.1995
(51) Int. Cl.: H01L 31/18, H01L 31/0216, H01L 21/00, H01L 31/036

(54) **Verfahren zur Bearbeitung von dünnen Wafern und Solarzellen aus kristallinem Silizium**

(30) Priorität: 29.04.1994 DE 4415132
(71) Anmelder: SIEMENS AKTIENGESELLSCHAFT, D-80333 München (DE); Siemens Solar GmbH, D-80807 München (DE)
(72) Erfinder: Endrös, Arthur, Dr., D-80337 München (DE); Eisenrith, Karl-Heinz, D-83727 Schliersee (DE); Martinelli, Giuliano, Prof., I-44100 Ferrara (IT)
(74) Vertreter: Fuchs, Franz-Josef, Dr.-Ing.

(57) **Zusammenfassung**

Dünne Halbleiterscheiben (Wafer) und daraus hergestellte Bauelemente wie beispielsweise Solarzellen aus kristallinem Silizium unterliegen wegen der Sprödigkeit des Materials einer erhöhten Bruchgefahr und erfordert für den Wafer eine Mindestdicke, um eine sichere Handhabung zu gewährleisten. Zur Verbesserung der Handhabung wird nun vorgeschlagen, die Halbleiterscheibe ganzflächig mit einer mechanischen Schutzschicht zu versehen und diese erst anschließend einer formgebenden Behandlung zu unterziehen.

## Beschreibung

Solarzellen aus kristallinem Silizium (c-Si) sind für den terrestrischen Einsatz weit verbreitet. Die an Solarzellen gestellten Forderungen nach Umweltverträglichkeit, großflächiger Erzeugbarkeit, hoher Effizienz und Preiswürdigkeit werden von diesen Solarzellen gut erfüllt. Gegenüber Dünnschichtsolarzellen aus amorphem Silizium (a-Si:H), Kupfer-Indium(Gallium)-Diselenid(CIS, CGS) und Kadmiumtellurid (CdTe) haben sie neben den genannten Vorteilen aber auch einige Nachteile.

Kristallines Silizium ist außerordentlich spröde und infolgedessen leicht zerbrechlich. Handhabbare Wafer aus c-Si bzw. aus diesem Material hergestellte Solarzellen müssen derzeit eine Dicke von etwa 300 µm besitzen, um wegen der hohen Bruchgefahr eine sichere Verarbeitung und Handhabbarkeit gewährleisten zu können. Wegen der Zerbrechlichkeit muß die Formgebung des Wafers bislang durch ein geeignetes Besäumen des c-Si-Einkristallstabs, also bereits vor dem Sägen des Wafers vorgenommen werden. Die individuelle Formgebung für einen einzelnen Wafer bzw. für eine einzelne Solarzelle ist daher nicht oder nur sehr aufwendig möglich.

Bislang war es auch nicht möglich, aus kristallinem Silizium hergestellte Solarzellen auf stark gekrümmten Oberflächen aufzubringen, ohne daß dies zum Bruch der Solarzellen führt. Aus EP 0 221 287 B ist zwar ein Verfahren bekannt, mit dem Solarzellen aus kristallinem Silizium durch eine spezielle Laminiertechnik zwischen einem leicht gebogenen Träger und einer gleichermaßen gewölbten Glasscheibe eingebettet werden können, doch ist dieses Verfahren auf leicht gewölbte Oberflächen wie beispielsweise das Dach eines Kraftfahrzeuges beschränkt.

Aufgabe der vorliegenden Erfindung ist es daher, ein Verfahren zur Formgebung von Wafern aus kristallinem Halbleitermaterial anzugeben, welches die oben angegebenen Nachteile vermeidet und es in einfacher Weise erlaubt, Halbleiterscheiben und insbesondere Solarzellen auf gekrümmten Oberflächen aufzubringen oder ihnen eine gewünschte Form zu geben.

Diese Aufgabe wird erfindungsgemäß durch ein Verfahren mit den Merkmalen von Anspruch 1 gelöst.

Weitere Ausgestaltungen der Erfindung sind den Unteransprüchen zu entnehmen.

Es wurde festgestellt, daß eine dünne Halbleiterscheibe durch eine ganzflächig aufgebrachte mechanische Schutzschicht vor mikroskopischen Beschädigungen geschützt ist. Auf diese Weise wird der Rißbildung und dem Bruch der Halbleiterscheibe vorgebeugt. Voraussetzung dafür ist, daß die Schutzschicht dicht aufliegt, ausreichend fest haftet und ausreichend flexibel ist. Eine solche Schutzschicht erlaubt es, die Dicke der Halbleiterscheibe deutlich zu reduzieren, ohne dabei gleichzeitig die Bruchgefahr derselben zu erhöhen.

Eine erfindungsgemäß mit einer Schutzschicht versehene Halbleiterscheibe zeigt in einer reduzierten Dicke von beispielsweise 170 µm und weniger außerdem neue, nicht erwartete vorteilhafte Eigenschaften. Eine solche Halbleiterscheibe läßt sich gefahrlos biegen, ohne daß es gleich zum Bruch derselben kommt. Dabei werden in Abhängigkeit von der Dicke der Halbleiterscheibe Krümmungsradien von 20 cm und weniger erreicht. Dadurch ist es erstmals möglich, Halbleiterscheiben bzw. daraus hergestellte Bauelemente wie Solarzellen auf deutlich gekrümmten Oberflächen aufzubringen. Die Anwendungsmöglichkeiten solcher Bauelemente werden dadurch beträchtlich vergrößert. Beispielsweise lassen sich Solarzellen dadurch nun auf eindimensional stark gekrümmten Oberflächen, beispielsweise auf Gebrauchsgegenständen, Fahrzeugen oder Gebäudeaußenflächen in einfacher Weise direkt aufbringen, was bislang nicht möglich war. Ein weiterer Vorteil ergibt sich durch die verringerte Dicke der Halbleiterscheibe, die einerseits zur Einsparung von Halbleitermaterial bei der Fertigung flacher Bauelement führt und andererseits zusätzliche physikalische Vorteile für das Bauelement erbringen kann. In einer dünneren Solarzelle ist beispielsweise auch die Weglänge verkürzt, die die photovoltaisch erzeugten Ladungsträgerpaare im Innern des Halbleiters zurücklegen müssen, bis sie die stromsammelnden Kontakte auf Vorder- und Rückseite erreichen. Durch die geringere Weglänge vermindert sich die Rekombinationswahrscheinlichkeit, so daß mehr Ladungsträger gesammelt werden können und die Solarzelle einen höheren Wirkungsgrad erreicht.

Die im erfindungsgemäßen Verfahren eingesetzte mechanische Schutzschicht kann aus einem beliebigen Material hergestellt sein, welches die oben erwähnten Anforderungen erfüllt. Besondere Vorteile bietet eine Schutzschicht jedoch dann, wenn sie als funktionelle Schicht auf der Halbleiterscheibe bzw. dem daraus gefertigten Bauelement verbleiben kann, oder wenn sie sich in einfacher Weise wieder entfernen läßt.

Eine einfach aufzubringende und einfach wieder zu entfernende Schutzschicht besteht beispielsweise aus einem Kunststoff, der in flüssiger Form aufgebracht und anschließend gehärtet werden kann. Möglich ist es beispielsweise, ein organisches Polymer in einem geeigneten Lösungsmittel zu lösen, auf der Halbleiterscheibe aufzubringen, zu trocknen und gegebenenfalls zu härten.

Je nach Art des Polymers kann die Härtung thermisch, durch Einwirkung elektromagnetischer Strahlung oder durch Kombination beider Verfahren erfolgen. Ein entsprechend dünnflüssiges Polymer bzw. dessen kürzerkettige Vorläuferverbindung (Precursor oder Monomer) kann auch lösungsmittelfrei aufgebracht und erst durch die Härtung zum Feststoff werden. Das Polymer kann zum Beispiel eine strahlenhärtende Überzugsmasse oder auch ein Photolack sein. Möglich ist es jedoch auch, ein- oder zweikomponentige Reaktionsharze zu verwenden. Beispielsweise können Epoxidharze durch Verwendung geeigneter Photoinitiatoren als rein durch Strahlung aushärtende Systeme ausgestaltet werden. Eine aus einer Harz- und einer Härterkomponente bestehende Reaktionsharzmischung wird unmittelbar vor den Aufbringen auf die Halbleiterscheibe zusammengemischt und kann bereits bei milden Temperaturen ausgehärtet werden.

Eine mechanische Schutzschicht, die gleichzeitig eine funktionelle Schicht des aus der Halbleiterscheibe herzustellenden Bauelementes darstellt, ist beispielsweise eine elektrisch leitende Schicht. Eine erfindungsgemäß aufzubringende Schutzschicht kann daher auch eine Metallschicht sein. Dazu ist allerdings erforderlich, daß ein ausreichend flexibles Metall verwendet wird.

Eine weitere geeignete Schutzschicht kann aus einer aufgedruckten und eingebrannten Leitpaste bestehen. Diese umfaßt neben einem hohen Anteil metallischer Partikel zumindest noch eine sinterfähige keramische Komponente und gegebenenfalls ein organisches Bindemittel zum Einstellen der Gebrauchseigenschaften. Bekannte leitfähige Pasten enthalten beispielsweise Silber, Zinn oder deren Legierungen zusammen neben Glaspartikeln.

Die leitfähigen Pasten lassen sich in einfacher Weise auf der Halbleiterscheibe ganzflächig aufdrucken und stellen nach dem Einbrennen eine gut haftende, mechanisch stabile Schutzschicht für die Halbleiterscheibe dar. Für das daraus herzustellende Bauelement können sie als stromabführender Kontakt dienen.

Für das erfindungsgemäße Verfahren ist es ausreichend, wenn die Schutzschicht in einer Dicke von 10 bis 20 µm aufgebracht wird. Da die Dicke der Schutzschicht neben der Dicke der Halbleiterscheibe ganz wesentlich von den Materialeigenschaften der Schutzschicht bestimmt wird, können auch darüber hinausgehende Schutzschichtdicken möglich oder erforderlich sein. Es hat sich gezeigt, daß das erfindungsgemäße Verfahren selbst bei der Verwendung einer aus einem weichen Polymeren gefertigten Schutzschicht zu einer verbesserten Bearbeitbarkeit und einer höheren Flexibilität der Halbleiterscheibe führt.

Besonders vorteilhaft wird das erfindungsgemäße Verfahren zur Bearbeitung von Halbleiterscheiben eingesetzt, welche dünne Siliziumtrikristallwafer sind. Ein solcher Trikristall ist aus einem Artikel von G. Martinelli in Solid State Phenomena Vol. 32 bis 33 (1993), Seiten 21 bis 26, bekannt. Dieser Trikristall besteht aus drei gegenander verkippten monokristallinen Bereichen. Die Phasengrenzen zwischen jeweils zwei monokristallinen Bereichen werden von Ebenen gebildet. Es existieren drei solcher Ebenen, die sich entlang einer Geraden schneiden. Keine dieser Ebenen durchschneidet jedoch den gesamten Trikristall. Vorzugsweise werden die Grenzflächen zwischen jeweils zweien der monokristallinen Bereiche von kristallographisch definierten Ebenen des Siliziumkristalls gebildet und stellen [111]-Ebenen dar. Demzufolge schneiden sich auch die durch diese Grenzflächen definierten Ebenen in kristallographisch vorgegebenen Winkeln, die im Idealfall die Werte von 109,47° und 125,26° annehmen.

Ein solcher Trikristall hat den Vorteil, daß er keine schräg durch den Kristall laufenden [111]-Ebenen enthält. Ein herkömmlicher Siliziummonokristall weist dagegen mehrerer solcher Ebenen auf. Parallel zu diesen Ebenen können beim Kristallziehen Versetzungen entstehen, die beim späteren aus dem Kristall gesägten Wafer Vorzugsbruchstellen darstellen. Beim Trikristall dagegen existiert keine solche den gesamten Kristall durchschneidende Versetzungsebene.

Aus einem solchen Trikristall können dünne Wafer gesägt werden, die für ihre geringe Dicke außergewöhnlich bruchstabil sind. So können beispielsweise Wafer mit einer Dicke von nur 60 µm in hoher Ausbeute von zum Beispiel 95% aus dem Trikristall gesägt werden.

Ein aus einem Siliziumtrikristall gesägter, dünner Wafer wird mit Hilfe des erfindungsgemäßen Verfahrens derart stabilisiert, daß er ungewöhnliche und bislang nicht bekannte Eigenschaften erlangt. Wird ein Siliziumtrikristallwafer von 30 bis 150 µm Dicke mit einer 10 bis 20 µm dicken organischen Schutzschicht versehen, läßt er sich fast wie ein Blatt Papier handhaben, ohne zu brechen. Ein erfindungsgemäß beschichteter Siliziumtrikristall ist ungewöhnlich flexibel und erreicht - ohne zu zerbrechen - Krümmungsradien bis 2 cm und weniger.

Ein solcher beschichteter Siliziumtrikristallwafer kann im erfindungsgemäßen Verfahren in eine beliebige äußere Form gebracht werden. Durch einfaches Ausstanzen oder Schneiden mit einer Klinge kann der Wafer bzw. das daraus hergestellte Bauelement in eine beliebige äußere Form gebracht werden, ohne daß das Bauelement beschädigt wird. Die Polymerschicht kann danach mittels eines Lösungsmittels wieder entfernt werden. Der beschichtete Siliziumtrikristallwafer ist dabei so stabil, daß selbst das Ausstanzen eines "Loches" mit beliebigem Umriß aus der Mitte des Wafers möglich wird. Mit dem erfindungsgemäßen Verfahren kann ein solcher Wafer in praktisch jede denkbare äußere Form gebracht werden und beispielsweise als Solarzelle ausgebildet auf beliebig geformten Unterlagen bzw. Oberflächen aufgebracht werden. Solche Oberflächen können dann selbst Erhebungen aufweisen, für die in der Solarzelle dann eine entsprechend geformte Ausnehmung vorgesehen ist bzw. erzeugt wird.

Im folgenden wird die Erfindung anhand von zwei Ausführungsbeispielen und der dazugehörigen sechs Figuren näher erläutert. Dabei zeigen
- die Figuren 1 bis 4: eine mit einer Schutzschicht versehene Halbleiterscheibe während verschiedener Bearbeitungsstufen.
- Figur 5: zeigt einen Siliziumtrikristallwafer in der Draufsicht.
- Figur 6: zeigt eine Halbleiterscheibe mit einer Ausnehmung in der Draufsicht.

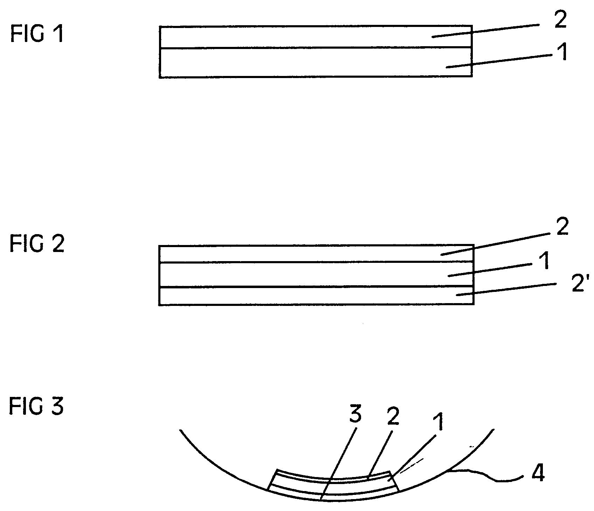

Aufbringen einer Schutzschicht auf einer Halbleiterscheibe (Figur 1):
a) Aufbringen einer Schicht eines organischen Polymers.
   Auf einer Halbleiterscheibe 1 aus kristallinem Silizium mit einer Dicke von unter 170 µm wird zunächst eine Schutzschicht 2 aus einem organischen Polymer aufgebracht. Es wird ein UV-härtbarer, negativ arbeitender Photoresist verwendet. Der Photoresist wird als Lösung aufgesprüht, aufgepinselt oder wie in der Halbleiterfertigung üblich aufgeschleudert. Nach dem ganzflächigen Aufbringen der Schutzschicht 2 wird diese getrocknet. Zur Beschleunigung kann die Schutzschicht 2 ausgeheizt und/oder angehärtet werden. Dazu ist ein zehnsekündiges Aufheizen auf 150° ausreichend.
   Zur Aushärtung wird die Schutzschicht 2 mit einer UV-Strahlenquelle bestrahlt und beispielsweise eine Sekunde lang einer Strahlung von 380 nm ausgesetzt. Die ausgehärtete Schutzschicht 2 zeigt eine gute Haftung auf der Halbleiterscheibe 1 und besitzt eine Dicke von 10 bis 20 µm.
b) Erzeugen der Schutzschicht 2 aus leitfähiger Paste
   Mit Hilfe eines Siebdruckverfahrens wird eine Silber- und Sillziumdioxidpartikel-haltige Paste auf der Oberfläche der Halbleiterscheibe 1 ganzflächig aufgebracht. Es kann dazu eine herkömmliche Siebdruckpaste verwendet werden, wie sie standardmäßig in der Photovoltaic zur Herstellung von Rückkontakten Verwendung findet. Nach dem ganzflächigen Aufbringen der Paste wird der darin enthaltene organische Binder ausgebrannt, wobei die Pastenschicht mit Hilfe der darin enthaltenen SiO₂-Partikel auf dem Halbleiterkörper festsintert. Es wird eine gleichmäßige metallisch leitende Schutzschicht 2 von ca. 10 bis 20 µm Dicke erhalten.

Figur 2 zeigt in einer weiteren Ausführungsform der Erfindung eine Halbleiterscheibe 1, die auf beiden Oberflächen mit einer Schutzschicht 2 versehen ist. Dabei ist es möglich, für beide Schutzschichten 2 beziehungsweise 2' gleiches oder unterschiedliches Material zu verwenden. Möglich ist es beispielsweise, zunächst eine der Schutzschichten 2 aus einer metallisch leitfähigen Schicht und danach die zweite Schutzschicht 2' aus einem später aufzubringenden-organischen Polymer herzustellen.

Durchführen einer formgebenden Bearbeitung.

Eine mit zumindest einer Schutzschicht 2 versehene Halbleiterscheibe 1 ist nun fast wie ein Blatt Papier handhabbar und kann nun einem Formgebungsprozeß unterzogen werden. Ein solcher Formgebungsprozeß kann ein eindimensionales Verbiegen der Halbleiterscheibe beinhalten, beispielsweise um diese auf einer gekrümmten Oberfläche aufzukleben, aufzulaminieren oder sonst wie zu befestigen. Möglich ist es auch, die mit der oder den Schutzschichten 2 versehene Halbleiterscheibe 1 durch Stanzen, Sägen oder Schneiden in eine gewünschte äußere Form zu bringen, bzw. mit einem gewünschten Zuschnitt zu versehen.

Figur 3 zeigt eine mit einer Schutzschicht 2 versehene Halbleiterscheibe 1, die auf einem gewölbten Träger 4 aufgebracht wurde. Die Halbleiterscheibe 1 ist beispielsweise eine Solarzelle, deren Schutzschicht 2 beispielsweise der durch Siebdruck und anschließendes Einbrennen aufgebrachte, metallisch leitende Rückkontakt ist. Als Träger 4 kann beispielsweise eine gebogene Glasscheibe dienen. Das Aufkleben kann mit Hilfe einer Kleberschicht 3 erfolgen. Im einfachsten Fall ist die Kleberschicht 3 eine thermoplastische Schmelzklebefolie, die zwischen der Solarzelle 1 und dem aus Glas bestehenden Träger 4 angeordnet wird. Unter Ausübung eines leichten äußeren Druckes wird die gesamte Anordnung nun über den Erweichungspunkt der Schmelzklebefolie gebracht und anschließend wieder abgekühlt. Dadurch wird der in Figur 3 dargestellte feste Verbund (Laminat) erzeugt.

Möglich ist es auch, als Schutzschicht eine beispielsweise aus Photolack bestehende organische Polymerschicht aufzubringen und auszuhärten. Nach der formgebenden Bearbeitung, beispielsweise dem Aufkleben auf einen gewölbten Träger, kann die Schutzschicht mit einem Lösungsmittel, beispielsweise mit Aceton, wieder entfernt werden.

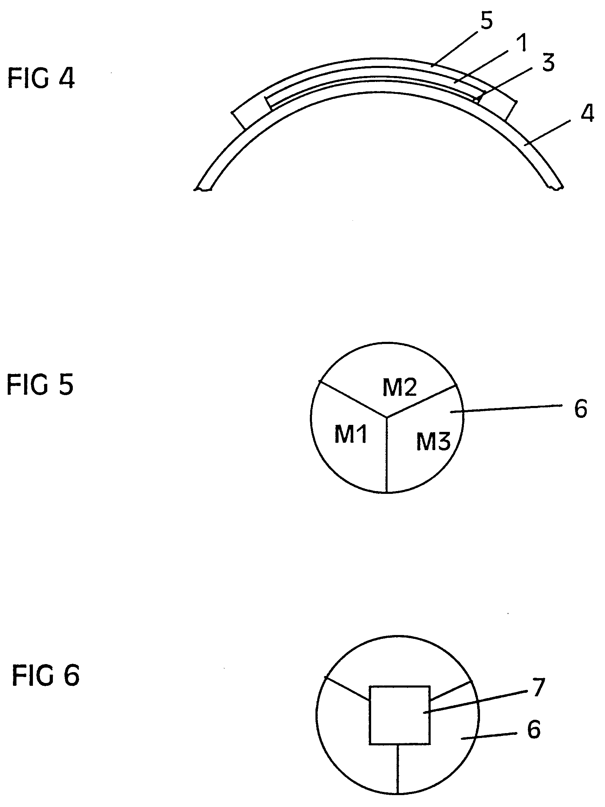

Figur 4 zeigt eine weitere Möglichkeit der formgebenden Bearbeitung. Auf einem nach außen gewölbten und beispielsweise aus Glas bestehenden Träger 4 wird mit Hilfe einer Klebeschicht 3 eine mit einer Schutzschicht 2 versehene Solarzelle 1 aufgeklebt. Die Schutzschicht 2 (in der Figur 4 nicht dargestellt) wird nach dem Aufkleben der Solarzelle 1 wieder entfernt. Zum Abdecken der Solarzelle wird nun eine weitere Schicht 5 auflaminiert, welche eine weitere thermoplastische Schmelzklebefolie sein kann, oder eine mit Hilfe einer solchen Schmelzklebefolie aufgebrachte Schutzfolie. Mit Hilfe der Abdeckung 5 wird das Laminat vervollständigt und die Solarzelle vollständig abgedeckt. Die Abdeckung 5 hat auf allen Seiten der Solarzelle 1 einen Überlapp, welcher bei dem Laminierprozeß mit der Unterlage bzw. mit dem Träger 4 eine feste Verbindung eingeht.

Figur 5 zeigt einen aus dem erwähnten Trikristall herausgesägten Trikristallwafer 6 in der Draufsicht. Die drei gegeneinander verkippten monokristallinen Bereiche M1, M2 und M3 stoßen in der Mitte aneinander, so daß keine der Grenzflächen eine den Trikristall durchschneidende Ebene ausbilden kann. Zwei der zwischen den monokristallinen Bereichen sind vorzugsweise [111]-Ebenen des Siliziums, bzw. Ebenen, die um maximal ± 2 Prozent von dieser kristallographisch definierten Ebene abweichen. An der dritten Grenzfläche bilden sich wegen des zur Verfügung stehenden größeren Winkels keine kristallographischen Ebenen aus. Man spricht hier von einer Grenzfläche zweiter Ordnung.

Eine aus einem solchen Siliziumtrikristallwafer 6 bestehende Halbleiterscheibe 1 kann in einer Dicke ab ca. 30 µm aus einem größeren Trikristallblock herausgesägt werden und wie zu den Figuren 1 und 2 beschrieben ein- oder beidseitig mit einer Schutzschicht 2 versehen werden. Auch in diesem Fall beträgt die Dicke der Schutzschicht 10 bis 20 µm. Die mit der Schutzschicht 2 versehene Halbleiterscheibe 1 (Trikristallwafer) zeigt eine ungewöhnliche Flexibilität und ist bruchstabil gegenüber formgebenden Bearbeitungen. Dabei läßt sich dieser Verbund ohne zu brechen extrem stark krummen, wobei Krümmungsradien von 2 cm und weniger erreicht werden können. Demzufolge läßt sich der Verbund auch auf einer entsprechend stark gekrümmten Unterlage durch Aufkleben oder Auflaminieren befestigen (siehe Figuren 3 und 4).

Figur 6: Möglich ist es jedoch auch, die mit der Schutzschicht 2 versehene Halbleiterscheibe 1 durch Ausstanzen oder Schneiden mit einem gewünschten Zuschnitt zu versehen. Dabei kann wie in der Figur 6 dargestellt auch eine beliebig geformte Ausnehmung 7 aus der Halbleiterscheibe 1 herausgenommen werden, ohne daß diese an mechanischer Stabilität verliert. Auch die mit der Ausnehmung 7 (und der Schutzschicht 2) versehene Halbleiterscheibe 1 kann einer weiteren formgebenden Bearbeitung unterzogen werden, und beispielsweise wiederum auf eindimensional gekrümmten Oberflächen aufgeklebt oder auflaminiert werden.

Besonders vorteilhafte Verwendung findet das erfindungsgemäße Verfahren bei der Herstellung von Solarzellen, wobei solche aus einem Trikristallwafer gefertigten einen gewünschten Zuschnitt erhalten können, der der Oberfläche angepaßt sein kann, auf der die Solarzelle befestigt werden soll. Weiterhin kann das erfindungsgemäße Verfahren dazu benutzt werden, die Solarzellen auf gekrümmten und insbesondere auf stark gekrümmten Oberflächen aufzubringen, was bislang mit Solarzellen aus kristallinen Silizium nicht möglich war.

Doch auch allgemein dient das erfindungsgemäße Verfahren dazu, bei der Herstellung von Solarzellen die Bruchgefahr der Halbleiterscheiben bei verschiedenen Bearbeitungsprozessen zu vermindern. Neben der erhöhten Verfahrenssicherheit bei der Handhabung der Halbleiterscheiben und bei der Fertigung von Solarzellen daraus wird es dabei möglich, die Solarzellen dünner als bislang auszuführen, was mit weiteren eingangs erwähnten Vorteilen für die Solarzelleneigenschaften verbunden ist.

## Patentansprüche

1. Verfahren zur formgebenden Bearbeitung einer dünnen Halbleiterscheibe (1), bei dem die Halbleiterscheibe vor der Bearbeitung ganzflächig mit einer mechanischen Schutzschicht (2) versehen wird.

2. Verfahren nach Anspruch 1,
bei dem die Schutzschicht (2) nach der formgebenden Bearbeitung wieder entfernt wird.

3. Verfahren nach Anspruch 1 oder 2,
bei dem die Schutzschicht (2) beidseitig auf die Hauptoberflächen der Halbleiterscheibe (1) aufgebracht wird.

4. Verfahren nach einem der Ansprüche 1 bis 3,
bei dem eine Halbleiterscheibe aus einem Siliziumtrikristallwafer (6) oder ein daraus hergestelltes Bauelement der formgebenden Bearbeitung unterzogen wird.

5. Verfahren nach einem der Ansprüche 1 bis 4,
bei dem als Schutzschicht (2) eine Schicht eines organischen Polymers in einer Dicke von ca. 10-50 µm aufgebracht wird.

6. Verfahren nach einem der Ansprüche 1 bis 4,
bei dem als Schutzschicht (2) eine metallisch leitende druckbare Paste aufgebracht wird.

7. Verfahren nach einem der Ansprüche 1 bis 6,
bei dem eine formgebende Bearbeitung durchgeführt wird, die ausgewählt ist aus Schneiden, Sägen und Stanzen.

8. Verfahren nach einem der Ansprüche 1 bis 6,
bei dem eine formgebende Bearbeitung durchgeführt wird, die ausgewählt ist aus Laminieren und einer Bearbeitung, die ein eindimensionales Verbiegen der Halbleiterscheibe (1) umfaßt.

9. Verfahren nach einem der Ansprüche 1 bis 8,
bei dem eine Halbleiterscheibe (1) mit einer Dicke von 30 bis 170 µm Dicke bearbeitet wird.

10. Verfahren nach einem der Ansprüche 1 bis 9,
bei dem die zu bearbeitende Halbleiterscheibe (1) eine Solarzelle ist.
